# EUROPÄISCHE PATENTANMELDUNG

(11) **EP 1 531 659 A2**
(43) Veröffentlichungstag der Anmeldung: **18.05.2005**
(21) Anmeldenummer: 04026675.1
(22) Anmeldetag: 10.11.2004
(51) Int. Cl.: H05K 5/00, H05K 5/04

(54) **Aus wenigstens einem Strangguss-Profil aufgebautes Gehäuse**

(30) Priorität: 14.11.2003 DE 10353284
(71) Anmelder: REO Inductive Components AG, 42657 Solingen (DE)
(72) Erfinder: Twellsieck, Friedel, 42659 Solingen (DE); Salditt, Christian, 16866 Kyritz (DE)
(74) Vertreter: Haft, von Puttkamer, Berngruber, Karakatsanis

(57) **Zusammenfassung**

Die Erfindung betrifft ein Gehäusemodul für ein Gehäuse mit einen Raum (5) umschließenden Seitenwänden (1, 2, 3, 4). Zumindest eine Seitenwand (1, 2, 3, 4) weist quer zur Längsrichtung der Seitenwand (1, 2, 3, 4) voneinander beabstandete Verbindungseinrichtungen (8, 9) zur Verbindung der Seitenwand (1, 2, 3, 4) mit einer entsprechenden Seitenwand (1, 2, 3, 4) eines weiteren, angrenzenden Gehäusemoduls (10) auf, wobei der Seitenwandbereich (30, 40) zwischen den Verbindungseinrichtungen (8, 9) entfernbar ist.

## Beschreibung

Die vorliegende Erfindung betrifft ein aus wenigstens einem Strangguss-Profil aufgebautes Gehäuse nach dem Oberbegriff des Patentanspruches 1.

Auf dem Gebiete der Elektrotechnik, insbesondere im Elektronikbereich werden Gehäuse, beispielsweise Filter-Gehäuse, wegen der geforderten EMV-Sicherheit aus Aluminium aufgebaut und je nach unterschiedlichen Leistungen bzw. Strömen dimensioniert. Dabei werden die einzelnen Gehäuse üblicherweise durch Stanzen und/oder Biegen und Nieten und/oder Verschrauben hergestellt. Ein Problem derartiger Herstellungsverfahren besteht darin, dass die Fertigungskosten relativ hoch sind und dass die einzelnen Gehäuse je nach Anforderung individuell dimensioniert werden müssen und daher nur in relativ kleinen Stückzahlen hergestellt werden können.

Da je nach individueller Anforderung derartige Gehäuse sowohl in liegender als auch in stehender Form verfügbar sein müssen, werden die Herstellungskosten weiter vergrößert.

Die Aufgabe der vorliegenden Erfindung besteht darin, ein Gehäuse zu schaffen, das relativ einfach und daher kostengünstig herstellbar ist, wobei es individuellen Anforderungen gerecht wird.

Diese Aufgabe wird durch ein Gehäuse mit den Merkmalen des Patentanspruches 1 gelöst.

Der wesentliche Vorteil der erfindungsgemäßen Gehäuse besteht darin, dass sie individuell unter Berücksichtigung von vorgegebenen Anforderungen, einfach und kostengünstig herstellbar sind, weil sie aus einzelnen Gehäusemodulen bestehen, die in einfacher Weise mit nur wenigen und kostengünstigen Operationen miteinander verbindbar sind. Auf diese Weise können Gehäuse unter Verwendung mehrerer, gleicher Gehäusemodule einfach zusammengesetzt und erstellt werden, wobei sie im Hinblick auf individuelle Anforderungen (wie z.B. die Größe des umschlossenen Volumens, die Breite, die Höhe, die Ausführung in liegender oder stehender Form), ausgelegt werden. Bei den einzelnen Gehäusemodulen handelt es sich vorzugsweise um Strangguss-Profile, die insbesondere aus Aluminium bestehen und je nach Anforderung seitlich miteinander verbunden werden, wobei zuvor die einander zugewandten Seitenwände zwischen endseitig angeordneten Verbindungseinrichtungen geöffnet, insbesondere aufgefräst, werden.

Bei einer besonderen Ausführungsform der Erfindung bestehen die Verbindungseinrichtungen zum Verbinden der einzelnen Gehäusemodule aus speziellen, in den einander zugewandten Seitenwänden endseitig angeordneten schwalbenschwanzförmigen Nuten, die beim Aneinandersetzen zweier Gehäusemodule einander zugewandt sind, wobei in zwei aneinander liegende Nuten komplementär zu dem durch die Nuten gemeinsam gebildeten Raum ausgebildete Verbindungselemente eingeschoben werden.

Weitere vorteilhafte Ausgestaltungen der Erfindung gehen aus weiteren Unteransprüchen hervor.

Im Folgenden werden die Erfindung und deren Ausgestaltungen im Zusammenhang mit den Figuren näher erläutert. Es zeigen:
- Figur 1: in schematischer Darstellung ein Gehäusemodul in stehender Anordnung;
- Figur 2: in schematischer Darstellung das Gehäusemodul der Figur 1 in liegender Anordnung;
- Figur 3: ein aus drei Gehäusemodulen aufgebautes Gehäuse und;
- Figuren 4: bis 9 Weiterbildungen der Erfindung.

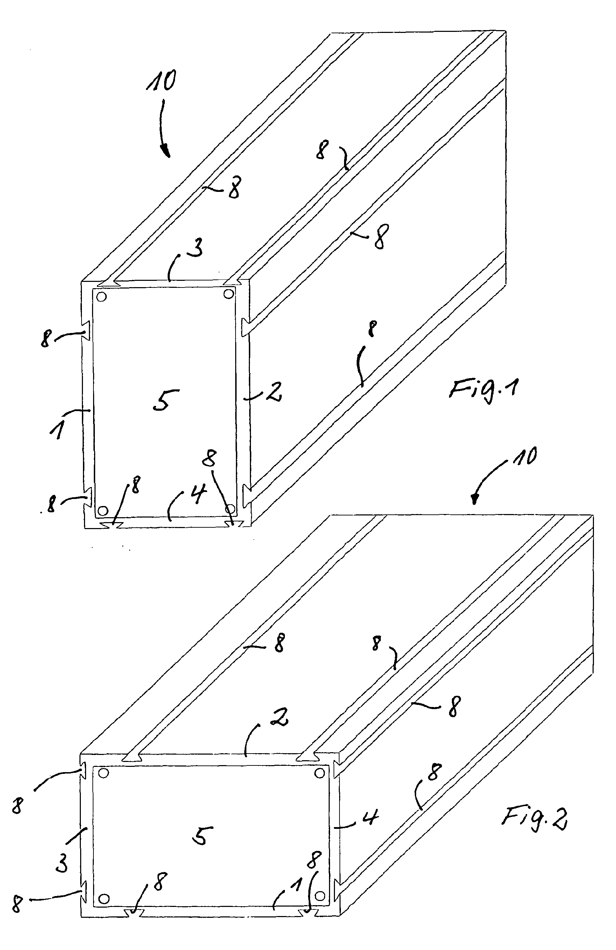

Die Figur 1 zeigt in stehender Anordnung ein ein einzelnes Gehäuse bildendes Gehäusemodul 10, das einen rechteckigen Querschnitt besitzt und vier Seitenwände 1, 2, 3, 4 aufweist, die einen Raum 5 umschließen. Vorzugsweise handelt es sich bei dem dargestellten Gehäusemodul 10 um ein Strangguss-Profil, das insbesondere aus Aluminium besteht, und vorderund rückseitig jeweils durch eine Deckelwand verschließbar ist, wie dies später noch näher erläutert wird.

Vorzugsweise jede Seitenwand 1, 2, 3 und 4 weist jeweils an einen Eckbereich angrenzend eine in Längsrichtung des Gehäusemoduls 10 verlaufende Nut 8 auf, wobei jeweils zwischen den beiden Nuten 8 einer Seitenwand 1, 2, 3, 4 ein Abstand besteht, in dem die Seitenwand beim Aufbau eines Gehäuses aus mehreren Gehäusemodulen 10 entfernt wird, wie dies ebenfalls später näher erläutert wird.

Vorzugsweise sind die Nuten 8 in der dargestellten Weise schwalbenschwanzförmig ausgebildet.

Die Figur 2 zeigt das Gehäusemodul 10 der Figur 1 in liegender Anordnung.

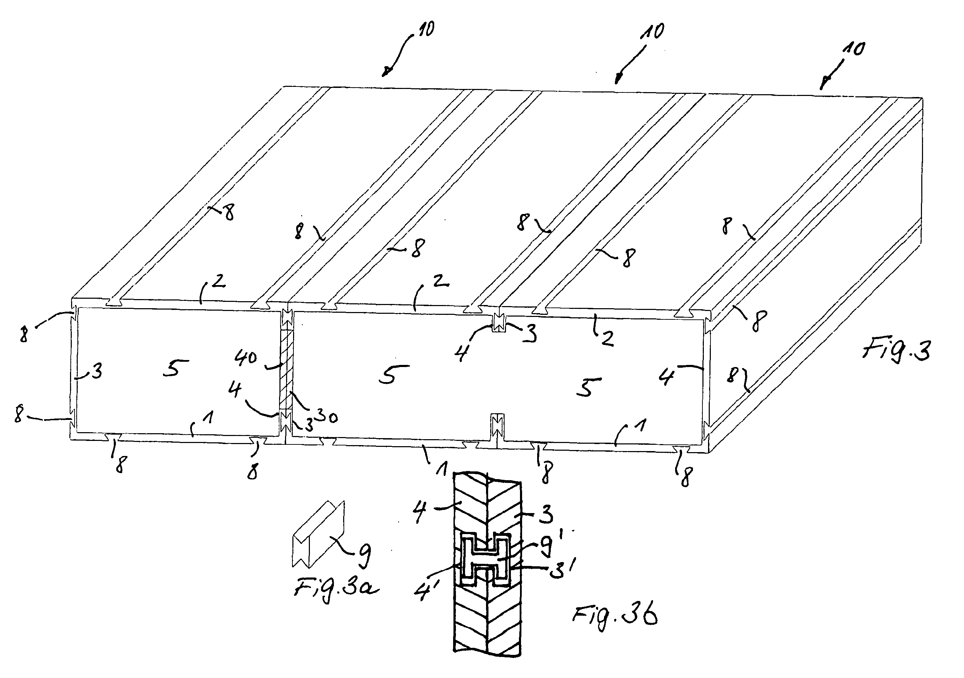

Figur 3 zeigt eine Anordnung, bei der ein Gehäuse aus drei liegenden Gehäusemodulen 10 gebildet ist. Es ist erkennbar, dass die einander zugewandten Seitenwände 3, 4 der links nebeneinander liegenden beiden Gehäusemodule 10 aneinander zur Anlage gebracht sind, wobei zuvor die zwischen den Nuten 8 der Seitenwände 3, 4 jeweils bestehenden Wandbereiche 30, 40 (schraffiert dargestellt) der Seitenwände 3, 4 durch eine geeignete Bearbeitungsoperation, vorzugsweise durch Fräsen oder Schneiden, entfernt wurden, wie dies im Bereich der Verbindung der beiden rechts nebeneinander angeordneten Gehäusemodule 10 dargestellt ist.

Gemäß Figur 3 ergibt sich auf diese Weise ein aus drei liegend nebeneinander angeordneten Gehäusemodulen 10 bestehendes Gehäuse, das insgesamt einen Innenraum umschließt, der dem dreifachen Raum 5 eines Gehäusemoduls 10 entspricht.

Besonders bevorzugt werden die Gehäusemodule 10 mit der Hilfe von Verbindungseinrichtungen 8, 9 miteinander verbunden, die aus den genannten schwalbenschwanzförmigen Nuten 8 sowie aus Schiebeelementen 9 bestehen, von denen eines beispielhaft in der Figur 3a dargestellt ist. In ersichtlicher Weise ist das Schiebeelement 9 derart ausgebildet, dass sein Querschnitt komplementär zu dem Querschnitt des Raumes ausgebildet ist, der durch die aneinander gesetzten Nuten 3 und 4 gebildet ist.

Gemäß Figur 10 sind auch andere hinterschnittene Nuten 4' denkbar, in denen zwei über einen Steg verbundene Nutsteine 9' gleitbar gehalten sind. Generell sind alle Verbindungseinrichtungen denkbar, durch die jeweils zwei Seitenwände 3, 4 im Bereich ihrer Eckbereiche miteinander verbindbar sind.

Es ist erkennbar, dass mit den vorliegenden Gehäusemodulen 10 Gehäuse in den unterschiedlichsten Abmessungen und Größen und Formen hergestellt werden können. Beispielsweise ist es auch denkbar, bei der Anordnung der Figur 3 oberseitig weitere Gehäusemodule 10 an den Seitenwänden 2 zu befestigen, sodass sich ein Gehäuse mit einem Volumen ergibt, das dem sechsfachen des Raumes 5 eines Gehäusemoduls 10 entspricht.

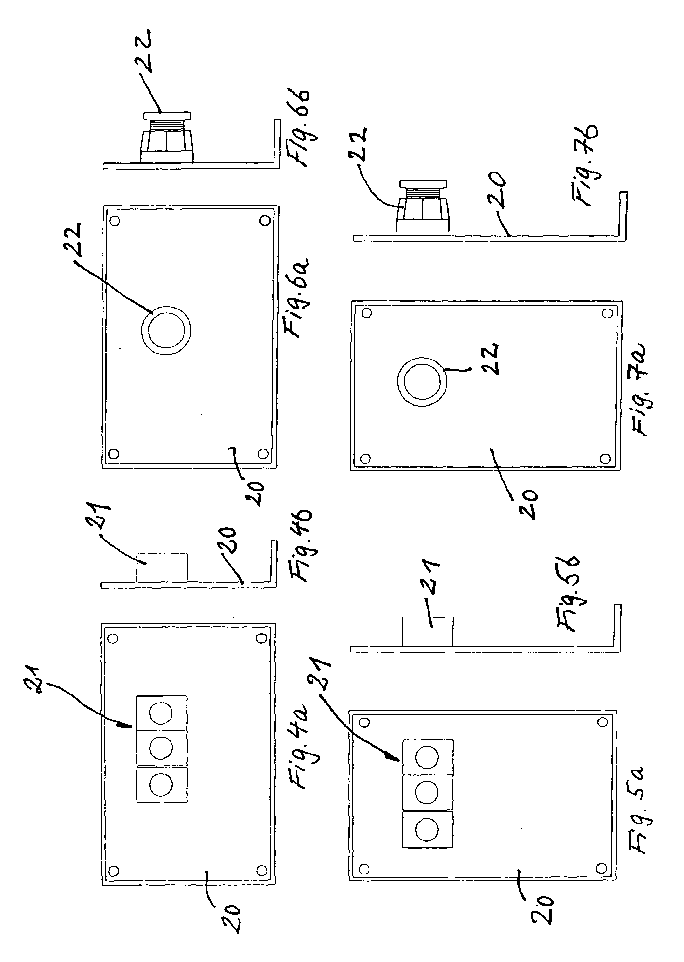

An den Gehäusemodulen 10 können stirnseitig Deckelwände 20, vorzugsweise mit der Hilfe von an sich bekannten Schnappelementen oder dergleichen, befestigt werden, wie dies die Figuren 4 bis 8 zeigen. Die Figuren 4a und 4b zeigen die Vorderansicht bzw. die Seitenansicht einer Deckelwand 20 mit Klemmleisten 21 für ein Filtergehäuse. Die Figuren 5a und 5b zeigen eine entsprechende Deckelwand 20 für ein Gehäusemodul eines Filtergehäuses in stehender Anordnung.

Die Figuren 6a und 6b zeigen eine Deckelwand 20 für ein Gehäusemodul 10 in liegender Anordnung, welche eine Kabeldurchführung 22 aufweist.

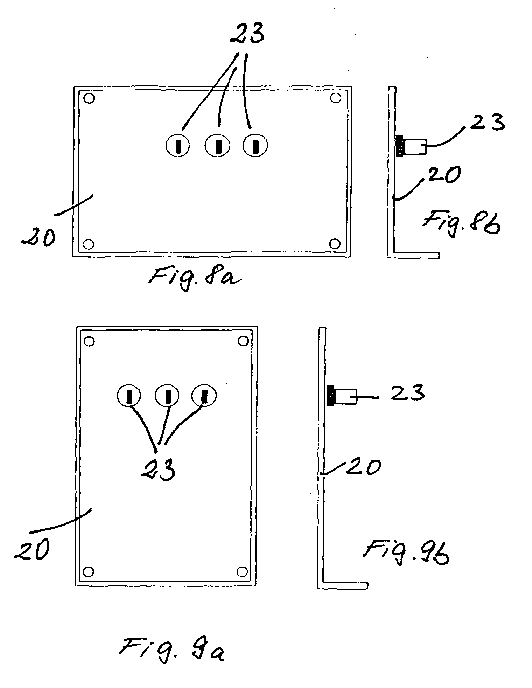

Die Figuren 7a und 7b zeigen eine entsprechende Deckelwand 20 für ein Gehäusemodul 10 in stehender Anordnung.

Die Figuren 8a und 8b zeigen eine Deckelwand 20 mit AMP-Buchsen 23 in liegender Anordnung. Die Figuren 9a und 9b zeigen eine entsprechende Deckelwand 20 für ein Gehäusemodul 10 in stehender Anordnung.

## Patentansprüche

1. Gehäusemodul für ein Gehäuse mit einen Raum (5) umschlieβenden Seitenwänden (1, 2, 3, 4), **dadurch gekennzeichnet, dass** zumindest eine Seitenwand (1, 2, 3, 4) quer zur Längsrichtung der Seitenwand (1, 2, 3, 4) voneinander beabstandete Verbindungseinrichtungen (8, 9) zur Verbindung der Seitenwand (1, 2, 3, 4) mit einer entsprechenden Seitenwand (1, 2, 3, 4) eines weiteren, angrenzenden Gehäusemoduls (10) aufweist, wobei der Seitenwandbereich (30, 40) zwischen den Verbindungseinrichtungen (8, 9) entfernbar ist.

2. Gehäusemodul nach Anspruch 1, **dadurch gekennzeichnet, dass** er einen rechteckigen Querschnitt besitzt.

3. Gehäusemodul nach Anspruch 1 oder 2, **dadurch gekennzeichnet, dass** die Verbindungseinrichtungen (8, 9) jeweils eine in der Längsrichtung der Seitenwand (1, 2, 3, 4) verlaufende Nut (8) mit Hinterschneidungen aufweist, in welche ein Schiebeelemente (9) zur Verbindung zweier Gehäusemodule (10) einschiebbar ist, wobei das Schiebeelement (9) eine komplementär zu dem Raum ausgebildet ist, der von zwei aneinanderliegenden Nuten (8, 8) zweier Seitenwände (3, 4) gebildet ist.

4. Gehäusemodul nach Anspruch 3, **dadurch gekennzeichnet, dass** die Nuten (8) schwalbenschwanzförmig ausgebildet sind.

5. Gehäusemodul nach Anspruch 3, **dadurch gekennzeichnet, dass** die Nuten ((3', 4') jeweils einen rechteckigen Querschnitt besitzen und an den Öffnungsrändern nach innen vorstehende Vorsprungbereiche aufweisen.

6. Gehäusemodul nach einem der Ansprüche 1 bis 5, **dadurch gekennzeichnet, dass** die Wandbereiche (30, 40) zwischen zwei Nuten (3', 3'; 4', 4') zweier Seitenwände (3, 4) durch Fräsen oder Schneiden entfernbar sind.

7. Gehäusemodul nach einem der Ansprüche 1 bis 6, **dadurch gekennzeichnet, dass** es aus einem Strangguss-Profil gebildet ist.

8. Gehäusemodul nach einem der Ansprüche 1 bis 7, **dadurch gekennzeichnet, dass** es aus Aluminium besteht.

9. Gehäusemodul nach einem der Ansprüche 1 bis 8, **dadurch gekennzeichnet, dass** es stirnseitig durch Deckelwände (20) verschließbar ist.

10. Gehäusemodul nach Anspruch 9, **dadurch gekennzeichnet, dass** die Deckelwände (20) mit der Hilfe von Schnappelementen am Gehäusemodul (10) befestigbar sind.

11. Gehäusemodul nach Anspruch 9 oder 10, **dadurch gekennzeichnet, dass** die Deckelwände (20) wenigstens eine Klemmleiste (21) und/oder wenigstens eine Kabeldurchführung (22) und/oder wenigstens eine Buchse (23) aufweisen.

12. Aus wenigstens zwei Gehäusemodulen gemäß einem der Ansprüche 1 bis 11 gebildetes Gehäuse, **dadurch gekennzeichnet, dass** die längeren Seitenwände (3, 4) der Gehäusemodule (10) in stehender Anordnung miteinander verbunden sind, wobei die längeren Seitenwände (3, 4)der Gehäusemodule (10) senkrecht zu einem Untergrund verlaufen.

13. Aus wenigstens zwei Gehäusemodulen gemäß einem der Ansprüche 1 bis 11 gebildetes Gehäuse, **dadurch gekennzeichnet, dass** die kürzeren Seitenwände (1, 2) der Gehäusemodule (10) in liegender Anordnung miteinander verbunden sind, wobei die längeren Seitenwände (3, 4)der Gehäusemodule (10) auf einem Untergrund anordenbar sind.

14. Aus Gehäusemodulen gemäß einem der Ansprüche 1 bis 11 gebildetes Gehäuse, **dadurch gekennzeichnet, dass** die Seitenwände einer ersten Reihe von Gehäusemodulen (10) in stehender Anordnung miteinander verbunden sind, wobei die längeren Seitenwände (3, 4) der Gehäusemodule (10) senkrecht zu einem Untergrund verlaufen, und dass auf der ersten Reihe deckungsgleich eine weitere Reihe von Gehäusemodulen (10) in stehender Anordnung angeordnet ist, deren längere Seitenwände (3, 4) miteinander verbunden sind, wobei die längeren Seitenwände (3, 4) senkrecht zum Untergrund verlaufen, und dass die einander zugewandeten und aufeinander aufliegenden kürzeren Seitenwände (1, 2) der Gehäusemodule (10) der ersten und zweiten Reihe miteinander verbunden sind.

15. Aus Gehäusemodulen gemäß einem der Ansprüche 1 bis 11 gebildetes Gehäuse, **dadurch gekennzeichnet, dass** die Seitenwände einer ersten Reihe von Gehäusemodulen (10) in liegender Anordnung miteinander verbunden sind, wobei die kürzeren Seitenwände (3, 4) der Gehäusemodule (10) senkrecht zu einem Untergrund verlaufen, und dass auf der ersten Reihe deckungsgleich eine weitere Reihe von Gehäusemodulen (10) in liegender Anordnung angeordnet ist, deren kürzere Seitenwände (3, 4) miteinander verbunden sind, wobei diese kürzeren Seitenwände (3, 4) senkrecht zum Untergrund verlaufen, und dass die einander zugewandeten und aufeinander aufliegenden längeren Seitenwände (1, 2) der Gehäusemodule (10) der ersten und zweiten Reihe miteinander verbunden sind.
